(19) Europäisches Patentamt / European Patent Office / Office européen des brevets

(11) **EP 2 915 302 B1**

(12) **FASCICULE DE BREVET EUROPEEN**

(45) Date de publication et mention de la délivrance du brevet:
**14.09.2016 Bulletin 2016/37**

(21) Numéro de dépôt: **13785440.2**

(22) Date de dépôt: **30.10.2013**

(51) Int Cl.:
**H04L 25/03** *(2006.01)*      **H04L 27/10** *(2006.01)*

(86) Numéro de dépôt international:
**PCT/EP2013/072675**

(87) Numéro de publication internationale:
**WO 2014/067980 (08.05.2014 Gazette 2014/19)**

(54) **PROCEDE ET DISPOSITIF DE DEMODULATION DE SIGNAUX MODULES GFSK SUR Q ETATS**

VERFAHREN UND VORRICHTUNG ZUR DEMODULATION VON Q-GFSK SIGNALEN

METHOD AND APPARATUS FOR DEMODULATING Q-ARY GFSK SIGNALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.10.2012 FR 1260374**

(43) Date de publication de la demande:
**09.09.2015 Bulletin 2015/37**

(73) Titulaire: **Safran Electronics & Defense 92100 Boulogne-Billancourt (FR)**

(72) Inventeur: **CHIODINI, Alain F-92100 Boulogne-Billancourt (FR)**

(74) Mandataire: **Regimbeau 139, rue Vendôme 69477 Lyon Cedex 06 (FR)**

(56) Documents cités:
- **SPETH M ET AL: "MLSE based detection for GFSK signals with arbitrary modulation index", COMMUNICATIONS, 2004 INTERNATIONAL ZURICH SEMINAR ON ZURICH, SWITZERLAND FEB.18-20, 2004, PISCATAWAY, NJ, USA,IEEE, 18 février 2004 (2004-02-18), pages 228-231, XP010697711, DOI: 10.1109/IZS.2004.1287431 ISBN: 978-0-7803-8329-6**
- **BENKESER C ET AL: "A 1mm2 1.3mW GSM/EDGE digital baseband receiver ASIC in 0.13 Â[mu]m CMOS", VLSI SYSTEM ON CHIP CONFERENCE (VLSI-SOC), 2010 18TH IEEE/IFIP, IEEE, PISCATAWAY, NJ, USA, 27 septembre 2010 (2010-09-27), pages 183-188, XP031806400, ISBN: 978-1-4244-6469-2**
- **READY M J ET AL: "DEMODULATION OF COCHANNEL FSK SIGNALS USING JOINT MAXIMUM LIKELIHOOD SEQUENCE ESTIMATION", PROCEEDINGS OF THE ASILOMAR CONFERENCE. PACIFIC GROVE, NOV. 1 - 3, 1993; [PROCEEDINGS OF THE ASILOMAR CONFERENCE], NEW YORK, IEEE, US, vol. 2 OF 02, 1 novembre 1993 (1993-11-01) , pages 1412-1415, XP000438539,**

**Description**

La présente invention se rapporte au domaine de la transmission de signal, plus précisément à la réception d'un signal modulé sur Q états par déplacement de fréquence avec filtrage gaussien. Elle concerne plus précisément un procédé de démodulation et de décodage d'au moins un tel signal reçu.

Dans les modulations à déplacement de fréquence à deux états, également désigné par l'acronyme FSK pour l'anglais Frequency-Shift-Keying, un 0 logique est représenté par un signal à la fréquence $f_0$ et un 1 logique par une fréquence $f_1$. Dans les modulations à déplacement de fréquence à quatre états, également désigné par l'acronyme QFSK pour l'anglais Quaternary Frequency-Shift-Keying, quatre fréquences réparties sur la largeur de bande sont chacune associées à un symbole.

Dans des modulations à déplacement de fréquence à phase continue, un oscillateur commandé par tension commande le signal de bit. Dans cette implémentation, il n'y a pas de changements de phase entre les transitions inter-bits, d'où le nom de phase constante. Cependant, du fait de la nature binaire du signal à moduler, de rapides changements de fréquence se produisent, et résultent en l'utilisation d'une large bande.

C'est pour diminuer cette largeur de bande que la modulation par déplacement de fréquence est préfiltrée par un filtre gaussien, d'où le nom de modulation par déplacement de fréquence à filtrage gaussien, également désigné par l'acronyme GFSK pour l'anglais Gaussian-Frequency-Shift-Keying.

Le filtrage gaussien réduit la largeur de bande du signal à moduler, et également la largeur de bande du signal modulé. Par conséquent, la modulation GFSK présente une meilleure efficacité spectrale qu'une modulation par déplacement de fréquence normale. La modulation GFSK est ainsi mise en oeuvre dans le cadre de norme telle que la norme Bluetooth ou DECT (pour l'anglais *Digital Enhanced Cordless Telephone* signifiant Téléphone sans-fil numérique amélioré).

Cependant, le modulateur à filtrage gaussien, ainsi que l'effet multi-trajet présent dans le canal de communication par lequel transite le signal, introduit des interférences entre symboles, de sorte que la démodulation du signal revêt un aspect non-linéaire la rendant complexe à réaliser.

Différents procédés ont été proposés pour la démodulation de signaux modulés par une modulation GSFK. Par exemple, l'article "MLSE Based Detection for GFSK Signals with Arbitrary Modulation Index", par Michael Speth et al., Int. Zurich Seminar on Communications, 18.02.2004, pages 228-231, iSBN 978-0-7803-8329-6, décrit un procédé de décodage de signaux GFSK présentant des indices de modulation arbitraires.

Les auteurs partent d'un modèle de transmission linéaire du signal GFSK, avec notamment la modélisation d'une fonction de transfert h modélisant l'influence du canal de transmission. Le signal GFSK reçu est

$$z(t) = \sum_k \left( a_k h(t - kT) \right)$$

avec le phaseur transmis

$$a_k = a_{k-1} e^{j\pi\eta b_k}$$

En pratique, le phaseur $a_{k-1}$ est remplacé par son estimée $\hat{a}_{k-1}$, qui est estimé au moyen d'un treillis de Viterbi et basé sur les décisions prises à chaque étape de Viterbi. Une métrique pour une transition est basée sur la différence entre le signal reçu et un signal reconstruit à partir d'états précédemment estimés.

L'article "A 1mm2 1.3mW GSM/EDGE Digital Baseband Receiver ASIC in 0.13$\mu$m CMOS", par Benseker et al., VLSI System ou Chip Conference, 27.09.2010, pages 183-188, iSBN: 978-1-4244-6469-2, décrit la démodulation de signaux de type GMSK (Gaussian minimum-shift keying) au moyen d'un égaliseur MLSE, et vise à réduire la complexité du calcul des métriques. Dans ce procédé, une estimation de la réponse impulsionnelle du canal de transmission est déterminée et un pré-filtre résultant est appliqué au signal reçu, avec mise en oeuvre d'un estimateur DFSE (Decision-Feedback Sequence Estimator).

L'article "Demodulation of Cochannel FSK Signals Using Joint Maximum Likelihood Sequence Estimation", par Michael Ready et al., Proceedings of the ASILOMAR Conference, vol.2/2, 01.11.1993, pages 1412-1415, décrit un démodulateur JMLSE MEFSK (Joint Maximum Likelihood Sequence Estimation Manchester-encoded, frequency-skift keying) et met en oeuvre un algorithme de Viterbi.

Cependant, ces procédés ne donnent pas entièrement satisfaction, notamment en raison des exigences matérielles de ces procédés. En particulier, ces procédés ne permettent généralement pas de démoduler des signaux modulés par déplacement de fréquence à filtrage gaussien à quatre états (QGFSK).

PRESENTATION DE L'INVENTION

Un objectif de l'invention est de permettre une démodulation de signaux modulés sur Q états par déplacement de fréquence à filtrage gaussien, par exemple les modulations GSFK ou QGFSK, avec un minimum d'exigences matérielles pour la mise en oeuvre de la démodulation, tout en conservant une bonne qualité de démodulation et de décodage. Le démodulateur est assisté d'un égaliseur afin de discriminer au mieux les symboles reçus, altérés par l'interférence inter-symboles.

L'invention propose à cet effet selon un premier aspect un procédé de démodulation et de décodage d'au moins un signal reçu modulé sur Q états par déplacement de fréquence avec filtrage gaussien, ledit signal étant reçu d'un canal de communication et comportant un message constitué de symboles de message, ledit procédé étant caractérisé en ce que, pour déterminer un symbole de message,

- une pluralité d'incréments de phase possibles sont estimés par l'application d'un filtre linéaire à une pluralité de séquence de M produits de modulation sur Q états par déplacement de phase de symboles de message consécutifs possibles,
- la phase cumulée des précédentes itérations du procédé est ajoutée à chacun desdits incréments de phase possibles pour donner une phase estimée,
- le symbole de message est déterminé par sélection des symboles consécutifs possibles dont la phase estimée est la plus proche du signal reçu.

L'invention selon le premier aspect est avantageusement complétée par les différentes caractéristiques suivantes prises seules ou selon leurs différentes combinaisons possibles :

- lorsque la modulation par déplacement de fréquence est une modulation par déplacement de fréquence à filtrage gaussien à deux états, la modulation par déplacement de phase est une modulation par déplacement de phase binaire BPSK, ou
- lorsque la modulation par déplacement de fréquence est une modulation par déplacement de fréquence à filtrage gaussien à quatre états, la modulation par déplacement de phase est une modulation par déplacement de phase quaternaire QPSK;
- la sélection des symboles consécutifs possibles est mise en oeuvre au moyen d'un critère de maximum de vraisemblance;
- la sélection des symboles consécutifs possibles dont la phase estimée est la plus proche du signal reçu est mise en oeuvre au moyen d'un algorithme de Viterbi dont le treillis est déterminé par le filtre linéaire;
- une nouvelle phase cumulée est déterminée par l'ajout à la phase cumulée des précédentes itérations du procédé de l'incrément de phase correspondant à la modulation par déplacement de phase (B) du symbole de message ainsi déterminée, ladite nouvelle phase cumulée étant la phase cumulée pour l'itération subséquente du procédé;
- le filtre linéaire est obtenu par minimisation au sens des moindres carrés d'un critère d'erreur quadratique exprimant la différence entre des produits de modulation par déplacement de phase d'une séquence connue de symboles de message et une partie du signal reçu correspondant à ladite séquence connue de symboles de message;
- le filtre linéaire est une estimation d'une réponse impulsionnelle du canal de communication modélisé par M coefficients;
- la modélisation de la réponse impulsionnelle du canal de communication prend en compte le passage de la modulation des symboles depuis une modulation par déplacement de phase (PSK) à une modulation par déplacement de fréquence (FSK);
- la réponse impulsionnelle du canal de communication est estimée à partir d'une séquence connue de symboles présente dans le signal reçu, ledit procédé comprenant les étapes suivantes:

  - extraction des symboles correspondant à la séquence connue de symboles contenue dans le signal reçu,
  - construction d'un signal de référence R par produit des modulations par déplacement de phase des symboles de la séquence connue,
  - construction d'une matrice P à partir des composantes du signal de référence R,
  - détermination de la matrice H modélisant la réponse impulsionnelle du canal de communication par application de ladite matrice P à un vecteur V dont les composantes correspondent aux symboles de la séquence connue;

- la matrice P correspond à la pseudo-inverse de Penrose d'une matrice de Hankel M de dimension (L-M)xM constituée des composantes du signal de référence R, où L est le nombre de symboles de la séquence connue.

L'invention selon un deuxième aspect concerne également un démodulateur-égaliseur pour démoduler et décoder au moins un signal reçu modulé sur Q états par déplacement de fréquence avec filtrage gaussien, comprenant au moins une mémoire et un processeur, ledit processeur étant configuré pour mettre en oeuvre le procédé selon le premier aspect. Le deuxième aspect de l'invention porte également sur un récepteur pour recevoir un signal modulé par déplacement de fréquence avec utilisation d'un filtre gaussien GFSK à Q états, comprenant au moins un démodulateur-égaliseur selon le deuxième aspect.

L'invention selon un troisième aspect porte également sur un produit programme d'ordinateur comprenant des instructions de code de programme pour l'exécution des étapes du procédé selon le premier aspect, lorsque ledit programme est exécuté par un système de calcul comprenant au moins un processeur. Typiquement, ce produit programme d'ordinateur prend la forme d'un support d'information lisible par un ordinateur.

PRESENTATION DES FIGURES

D'autres caractéristiques, buts et avantages de l'invention ressortiront de la description qui suit, qui est purement illustrative et non limitative, et qui doit être lue en regard des dessins annexés sur lesquels:

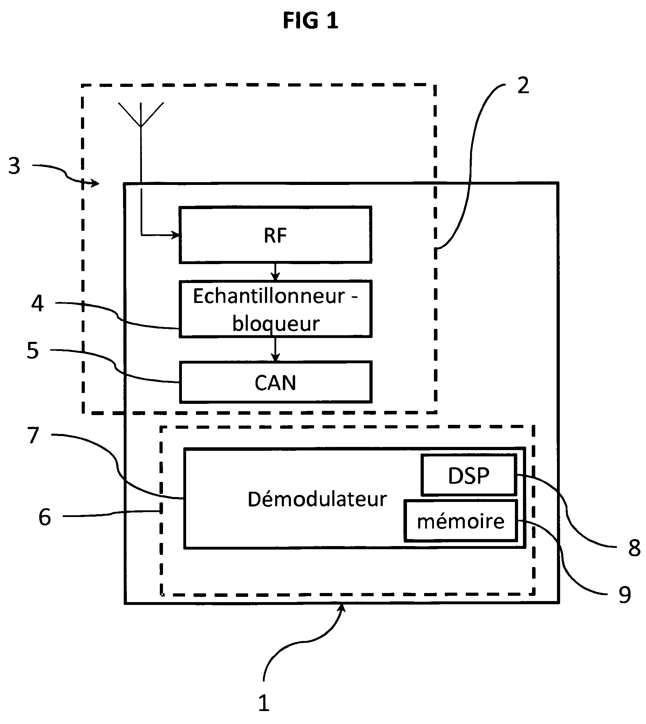

- la figure 1 est un schéma illustrant un récepteur muni d'un démodulateur-égaliseur selon l'invention pour mettre en oeuvre le procédé selon l'invention;
- la figure 2 est un schéma de principe illustrant l'enchaînement de différentes étapes d'un mode de réalisation possible du procédé selon invention;
- la figure 3 est un schéma de principe illustrant différentes étapes d'un mode possible de détermination de la modélisation du canal de communication selon un mode de réalisation possible du procédé selon l'invention;
- la figure 4 est un schéma illustrant partiellement la construction d'un treillis pour deux noeuds de celui-ci;
- la figure 5 est un graphique dont les différentes courbes illustrent des résultats de simulation de mises en oeuvre de modes de réalisation possibles du procédé selon l'invention;
- la figure 6 est un graphique illustrant le bruit de phase utilisé pour certaines mises en oeuvre de modes de réalisation possibles du procédé selon l'invention dont les résultats sont illustrés sur la figure 5.

DESCRIPTION DETAILLEE

La réception d'un signal modulé sur Q états par déplacement de fréquence avec filtrage gaussien fait appel à un récepteur 1 réalisant les différentes fonctions nécessitées par une telle réception. Ce récepteur 1 peut être un émetteur-récepteur, mais dans la mesure où la présente invention concerne la réception du signal, la présente description ne portera que sur la réception via le récepteur 1, dont un fonctionnement purement illustratif, bien que typique, est décrit ci-dessous.

Le signal est reçu par le biais d'une partie radiofréquence 2 comportant au moins une antenne 3 associé à des moyens de réception et de traitement radiofréquences pour recevoir le signal, un échantillonneur-bloqueur 4 et un convertisseur analogique-numérique 5 pour traiter le signal reçu. Le signal reçu est ensuite traité par un étage de traitement 6 pour être filtré numériquement, puis traité notamment par détection des fronts montants afin de réaliser un contrôle automatique de gain commandant notamment la partie radiofréquence.

Le récepteur procède à l'acquisition et au maintien de la synchronisation, et procède au moyen d'un processeur 8 d'un démodulateur-égaliseur 7 à la démodulation du signal, puis au désentrelacement et au décodage de canal, suivi par un débrouillage binaire, pour enfin restituer la source binaire à l'origine du signal.

Le rôle du démodulateur-égaliseur 7 est de convertir le signal modulé par QGFSK reçu en une séquence binaire qui sera subséquemment transmise vers le décodeur de canal. Il comprend au moins un processeur 8, de préférence un processeur de traitement de signaux numérique, ou DSP pour l'anglais Digital Signal Processor, et de préférence une mémoire 9.

Dans la suite, nous supposerons que l'acquisition de la synchronisation fréquentielle et temporelle a été effectuée et que la phase du signal reçu échantillonnée à la fréquence symbole est disponible.

Le procédé de démodulation selon l'invention, ainsi que le démodulateur-égaliseur qui le met en oeuvre, vise à reconstruire itérativement un signal modulé sur Q états par déplacement de fréquence avec filtrage gaussien (GFSK) à partir d'un signal de référence modulé sur Q états par déplacement de fréquence filtré à l'aide d'un filtre linéaire.

L'invention tire parti d'une propriété inédite découverte par la demanderesse, selon laquelle le $k^{ème}$ symbole d'un message modulé par déplacement de fréquence à filtrage gaussien correspond à une somme de produits de modulations par déplacement de phase du même message, les produits de modulations étant pondérés par les coefficients d'un filtre linéaire qui modélise le canal de communication en y incorporant le passage de la modulation par déplacement de phase à la modulation par déplacement de fréquence.

Ainsi, si GFSK(k) désigne la modulation par déplacement de fréquence à filtrage gaussien à deux états du k$^{ème}$ symbole de message, M le nombre de coefficients du filtre linéaire, H(m) le m$^{ième}$ coefficient dudit filtre linéaire modélisant la réponse impulsionnelle du canal de communication, et BPSK(l) la modulation par déplacement de phase binaire du l$^{ème}$ symbole de message d'origine, la formule suivante peut être établie :

$$GFSK(k) = \sum_{m=0}^{M-1} H(m)X(k-m)$$

avec

$$X(k) = \prod_{l=1}^{k} BPSK(l)$$

et dans le cas d'une modulation à quatre états QGFSK:

$$QGFSK(k) = \sum_{m=0}^{M-1} H(m)X(k-m)$$

avec

$$X(k) = \prod_{l=1}^{k} QPSK(l)$$

Ainsi, il est possible de traiter le signal modulé par déplacement de fréquence par filtrage gaussien au moyen de modulations par déplacement de phase. La connaissance d'une séquence connue de symboles de message permet de déterminer les coefficients du filtre linéaire.

De fait, l'invention met en oeuvre une reconstruction itérative des signaux modulés par déplacement de fréquence avec filtrage gaussien reçus à partir de signaux de référence modulés par déplacement de phase.

Ainsi, selon l'invention,

- une pluralité d'incréments de phase possibles sont estimés par l'application d'un filtre linéaire à une pluralité de séquence de M produits de modulation sur Q états par déplacement de phase de symboles de message consécutifs possibles,
- la phase cumulée des précédentes itérations du procédé est ajoutée à chacun desdits incréments de phase possibles pour donner une phase estimée,
- le symbole de message est déterminé par sélection des symboles consécutifs possibles dont la phase estimée est la plus proche du signal reçu.

Lorsque la modulation par déplacement de fréquence est une modulation par déplacement de fréquence à filtrage gaussien GFSK à deux états, avec Q=2, la modulation par déplacement de phase est une modulation par déplacement de phase binaire BPSK.

Lorsque la modulation par déplacement de fréquence est une modulation par déplacement de fréquence à filtrage gaussien quaternaire QGFSK, à quatre états avec Q=4, la modulation par déplacement de phase est une modulation par déplacement de phase quaternaire QPSK.

Afin de suffisamment rendre compte des interférences inter-symboles sans trop alourdir le procédé, on choisit $2 \leq M \leq 4$. Un filtre linéaire à 3 coefficients a été jugé satisfaisant de sorte que de préférence M = 3.

De préférence, la sélection des symboles consécutifs possibles est mise en oeuvre au moyen d'un critère de maximum de vraisemblance, par exemple au moyen de l'algorithme de Viterbi dont le treillis est déterminé par le filtre linéaire. La description suivante sera faite dans le cas d'un mode de réalisation faisant intervenir un tel critère.

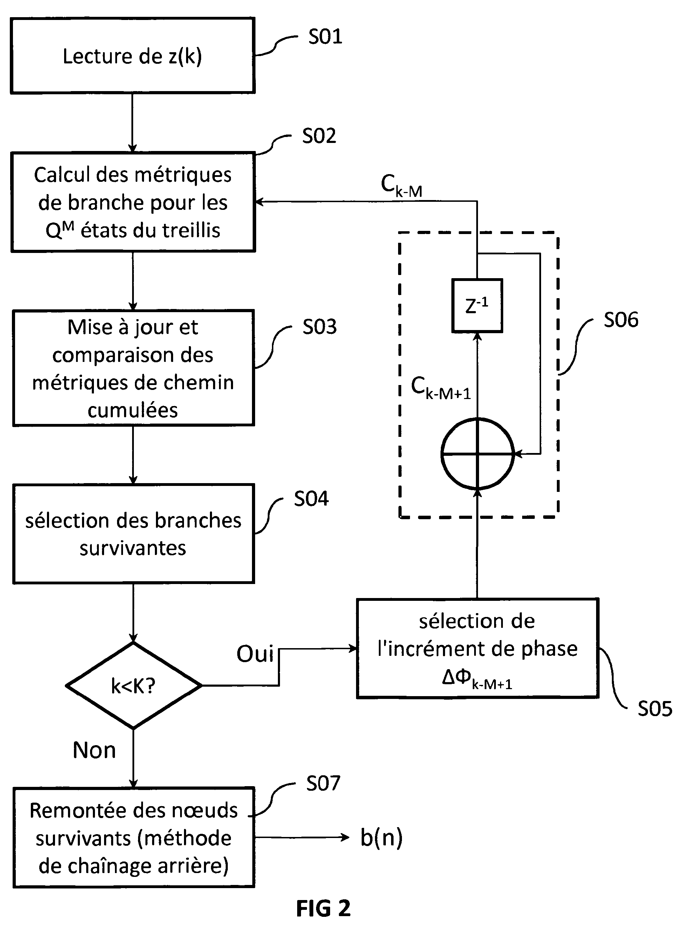

En référence à la figure 2, le procédé comprend une première étape S01 de lecture d'un symbole reçu z(k) faisant partie d'un signal reçu d'un canal de communication.

Un démodulateur-égaliseur MLSE (pour l'anglais Maximum Likelihood sequence estimation) estime la séquence de symboles émise au sens du maximum de vraisemblance : l'égaliseur compare les séquences de symboles reçues aux séquences théoriques pré-calculées. Si Q désigne le nombre d'états du schéma de modulation utilisé et N le nombre de symboles reçus alors il faut théoriquement calculer les distances euclidiennes entre la séquence reçue et les $Q^N$ séquences qu'il est possible de former et choisir parmi ces dernières la séquence donnant la plus petite distance.

La complexité de cet algorithme est malheureusement prohibitive car il faut calculer $Q^N$ distances euclidiennes pour chaque séquence reçue. Il est cependant possible de réduire considérablement le nombre d'opérations à effectuer en utilisant l'algorithme de Viterbi (utilisé traditionnellement dans les décodeurs de codes convolutifs) lorsque le nombre de coefficients M d'un filtre linéaire modélisant la réponse impulsionnelle du canal de communication est tel que $Q^M \leq 128$.

Il existe en effet une analogie entre le codage de canal effectué sur une suite binaire à l'aide d'un codeur convolutif et le passage d'un signal modulé à travers un canal de communication. Il est ainsi possible de générer de façon similaire un treillis à l'aide des coefficients de la modélisation de la réponse impulsionnelle du canal de communication.

Le procédé selon l'invention présente la particularité, par rapport à l'algorithme de Viterbi classique, de construire itérativement un signal de référence de bonne qualité, parallèlement à l'élaboration du treillis, la séquence binaire estimée est progressivement disponible (elle ne sera complète que lorsque le processus de mise à jour des métriques de chemin cumulées et de sélection des branches survivantes sera achevé).

Dans le cas d'une modulation à Q états, et d'un canal de communication modélisé par M états, $Q^M$ états sont possibles à chaque instant. A partir de la lecture du symbole reçu z(k), les métriques de branches sont calculées (étape S02) pour les $Q^M$ états du treillis qu'il est possible d'obtenir, au moyen des coefficients du filtre linéaire modélisant la réponse impulsionnelle du canal de communication.

La phase cumulée à l'instant k-M résultant des décisions successives prises sur les symboles précédemment reçus est connue, elle est notée $C_{k-M}$. En ajoutant à cette phase cumulée l'incrément de phase généré par M symboles consécutifs possibles préalablement filtrés avec la réponse impulsionnelle du canal de communication, le démodulateur est capable de calculer pour chacun des $Q^M$ M-uplets qu'il est théoriquement possible de former, les valeurs de phase correspondantes. Une métrique est ensuite associée à chaque M-uplet, par le calcul de la distance euclidienne entre la valeur de phase qui lui est associée et le signal reçu.

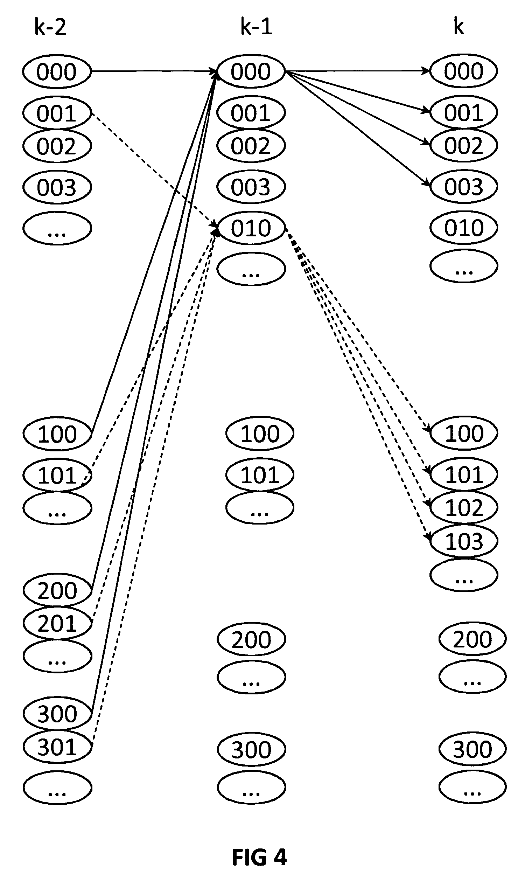

Prenons pour exemple le cas d'une modulation à quatre états, i.e. Q=4, et d'un canal de communication modélisé par trois coefficients (M=3). La figure 4 illustre un exemple de construction du treillis pour trois instants, de k-2 à k, dans lequel sont uniquement reproduits des chemins possibles partant et arrivant des suites 000 et 010 à l'instant k-1.

Pour chacune des 64 ($Q^M$) suites de trois symboles, ou triplets, à l'instant k, tels que 000, 001,..., chacun des trois coefficients modélisant le canal de communication est appliqué à un des trois symboles de la suite. Si ($h_0$, $h_1$, $h_2$) modélise le canal de communication, et si ($X_1$, $X_2$, $X_3$) sont les trois symboles du triplet constituant la suite, alors l'incrément de phase généré par les trois derniers symboles filtrés avec la modélisation du canal de transmission est $\Delta\Phi_{k-2} = h_0 X_3 + h_1 X_2 + h_2 X_1$.

Dans un régime de fonctionnement permanent, la phase cumulée $C_{k-3}$ est connue. L'incrément de phase correspondant $\Delta\Phi_{k-2}$ est ajouté à la phase cumulée $C_{k-3}$ pour donner la valeur de phase z correspondant à ce triplet ($X_1$, $X_2$, $X_3$) du treillis, correspondant à un noeud du treillis. Pour chacun des noeuds du treillis, la distance euclidienne entre cette valeur de phase z qui lui est associée et le signal reçu z est calculée selon:

$$\|z - \check{z}(X_1, X_2, X_3)\|^2$$

On obtient ainsi une métrique associé à chaque triplet.

Dans l'étape S03, les métriques de chemin cumulées sont mises à jour et comparées entre elles. Les branches survivantes sont ensuite sélectionnées (étape S04). Un noeud d'arrivée est constitué par une séquence de M symboles consécutifs possibles. Sur les Q branches menant à chaque noeud d'arrivée, l'algorithme de Viterbi requiert de n'en conserver qu'une et une seule. La branche la plus probable selon le critère du maximum de vraisemblance est conservée (c'est-à-dire celle dont la somme des métriques de branche et de chemin en provenance du noeud d'origine est la plus petite). Nous obtenons ainsi, pour chaque noeud d'arrivée, une nouvelle métrique de chemin qui est enregistrée en vue de l'itération suivante.

S'il ne s'agit pas de la fin du signal, c'est-à-dire si k<K, alors l'incrément de phase correspondant $\Delta\Phi_{k-M+1}$ est sélectionné (étape S05) afin de construire le signal de référence $C_{k-M+1}$ de la prochaine itération (étape S06) en ajoutant ledit l'incrément de phase $\Delta\Phi_{k-M+1}$ à la phase cumulée constituant le signal de référence $C_{k-M}$ précédemment utilisé.

Nous sélectionnons ensuite le noeud d'arrivée le plus probable parmi l'ensemble des noeuds d'arrivée. L'incrément de phase vraisemblablement réalisé entre les itérations k-M et k-M+1 est alors immédiatement connu et utilisé pour construire le futur signal de référence $C_{k-M+1}$ sur lequel s'appuiera la prochaine itération lorsqu'il s'agira calculer les nouvelles valeurs de phase associées aux $Q^M$ M-uplets possibles.

Enfin, à la fin du signal, k=K et on peut alors effectuer la remontée des noeuds survivants, selon la méthode dite de chaînage arrière (« trace back ») (étape S07). Cette étape est cependant optionnelle. En effet, le procédé présenté a la particularité, par rapport à un algorithme de Viterbi classique, de construire itérativement un signal de référence de bonne qualité, parallèlement à l'élaboration du treillis.

Par conséquent, la séquence binaire estimée est progressivement disponible (elle ne sera complète que lorsque le processus de mise à jour des métriques de chemin cumulées et de sélection des branches survivantes sera achevé) de sorte qu'il n'est a priori pas nécessaire d'exécuter le processus subséquent de remontée des noeuds survivants.

Afin d'augmenter la fiabilité du « trace back » effectué sur le treillis final et d'améliorer les performances de l'algorithme, chaque paquet se termine par M symboles connus. Ceci nous permet de connaître avec une certitude absolue le noeud final auquel aboutit l'ensemble des chemins survivants et donc de sélectionner la branche finale y menant la plus vraisemblable lors de l'itération K-M+1. Dès lors, il peut être avantageux d'effectuer le « trace back » complet du treillis en raison du gain de performance apporté par la présence des symboles connus en fin de paquet.

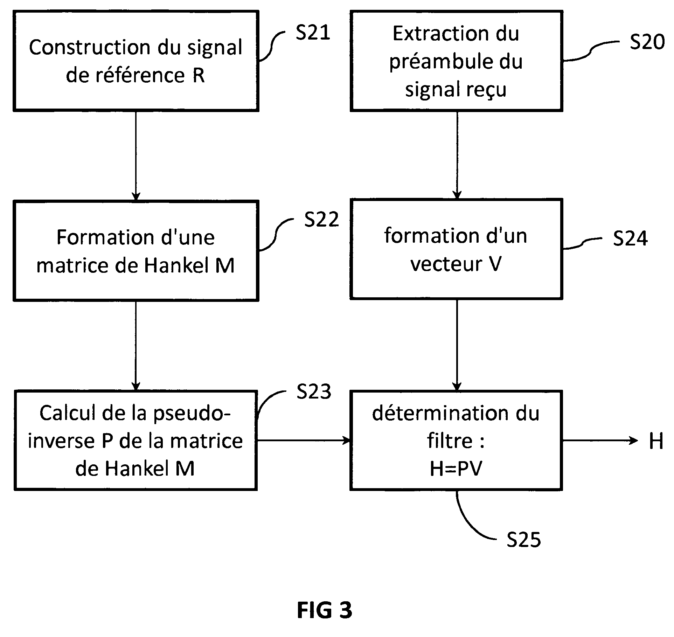

En référence à la figure 3, nous allons décrire l'obtention du filtre linéaire H. Le filtre linéaire est une modélisation, ou estimation, d'une réponse impulsionnelle du canal de communication par lequel est reçu le signal. Ce canal de communication est modélisé par M coefficients et prend en compte le passage de la modulation des symboles depuis une modulation par déplacement de phase à une modulation par déplacement de fréquence.

Le filtre linéaire est obtenu par minimisation au sens des moindres carrés d'un critère d'erreur quadratique exprimant la différence entre une séquence connue de symboles modulés par déplacement de phase et une partie du signal reçu correspondant à ladite séquence connue de symboles modulés par déplacement de phase.

La réponse impulsionnelle du canal de communication est estimée à partir d'une séquence connue de symboles présente dans le signal reçu, ladite séquence connue étant un préambule, aussi appelé champ de synchronisation.

L'estimation de la réponse impulsionnelle débute (étape S20) par l'extraction des symboles du préambule correspondant à la séquence connue de symboles contenue dans le signal reçu. Par exemple, le préambule est constitué de L symboles $b_0$, $b_1$, ..., $b_{L-1}$. Dans le cas de la norme DECT, L=32.

Les symboles sont connus du récepteur 1, qui dispose d'une copie locale, par exemple dans sa mémoire 9, ou d'un moyen de générer ladite séquence de symboles connue, comme un algorithme de génération de ladite séquence.

Cette séquence de symboles connus permet de construire (étape S21) un signal de référence R, dont la comparaison avec le préambule reçu permet d'estimer la réponse impulsionnelle du canal de communication. Ce signal de référence R est construit par le produit des modulations par déplacement de phase des symboles de la séquence connue.

$$b_0 \xrightarrow{\text{modulation BSPK}} BPSK_0 \; et \; X_0 = BPSK_0$$

$$b_1 \xrightarrow{\text{modulation BSPK}} BPSK_1 \; et \; X_1 = BPSK_1 . X_0$$

$$b_2 \xrightarrow{\text{modulation BSPK}} BPSK_2 \; et \; X_2 = BPSK_2 . X_1 = BPSK_2 . BPSK_1 . X_0$$

$$\vdots$$

$$b_{L-1} \xrightarrow{\text{modulation BSPK}} BPSK_{L-1} \; et \; X_{L-1} = BPSK_{L-1} . X_{L-2} = \prod_{l=0}^{L-1} BPSK(l)$$

D'une manière plus générale, dans le cas où la modulation par déplacement de fréquence est la modulation GFSK associée à la modulation BPSK, $X_k$ est estimé comme étant:

$$X(k) = \prod_{l=0}^{k-1} BPSK(l)$$

Dans le cas où la modulation par déplacement de fréquence est la modulation QGFSK associée à la modulation

QPSK, $X_k$ est estimé comme étant:

$$X(k) = \prod_{l=0}^{k-1} QPSK(l)$$

A partir des composantes de ce signal de référence R, une matrice P est construite, et la matrice H modélisant le canal de communication est déterminée par application de ladite matrice P à un vecteur V dont les composantes correspondent aux symboles du préambule : H=P×V

La matrice P correspond à la pseudo-inverse de Penrose d'une matrice de Hankel M de dimension (L-M)xM constituée des composantes du signal de référence R.

Ainsi, à partir des composantes $X_0$ à $X_{L-1}$, une matrice de Hankel M est construite (étape S22), constituée des symboles modulés $X_0$ à $X_{L-1}$ du signal de référence R. Cette matrice de Hankel M est une matrice non carrée dont les valeurs sont constantes le long des diagonales ascendantes. Cette matrice M a pour dimension (L-M)xM. La première colonne de cette matrice M correspond aux L-M premières composantes du signal de référence, de sorte que la matrice M se présente sous la forme:

$$M = \begin{pmatrix} X_0 & X_1 & \cdots & X_{M-1} \\ X_1 & X_2 & \cdots & X_M \\ X_2 & X_3 & \cdots & X_{M+1} \\ \vdots & \vdots & & \vdots \\ X_{L-M-1} & X_{L-M} & \cdots & X_{L-2} \\ X_{L-M} & X_{L-M+1} & \cdots & X_{L-1} \end{pmatrix} \text{ soit pour M=3: } M = \begin{pmatrix} X_0 & X_1 & X_2 \\ X_1 & X_2 & X_3 \\ X_2 & X_3 & X_4 \\ \vdots & \vdots & \vdots \\ X_{L-4} & X_{L-3} & X_{L-2} \\ X_{L-3} & X_{L-2} & X_{L-1} \end{pmatrix}$$

A partir de cette matrice M, on calcule (étape S23) une matrice P qui est la pseudo-inverse de Penrose de ladite matrice de Hankel M. La matrice P est calculée selon la formule suivante $P = (M^H \times M)^{-1} \times M^H$, avec $M^H$ la matrice transposée conjuguée de M, également appelée transconjuguée.

La matrice P peut ainsi être reconstruite par des calculs intermédiaires faisant intervenir une matrice de Hankel et sa pseudo-inverse de Penrose, ou bien être directement construite à partir des symboles modulés $X_0$ à $X_{L-1}$ du signal de référence R selon une organisation préalablement établie pour correspondre à la pseudo-inverse de Penrose de la matrice de Hankel M.

On forme alors un vecteur V dont les composantes correspondent aux symboles du préambule préalablement extraits (étape S24).

La matrice H du filtre linéaire modélisant le canal de communication est alors déterminée (étape S25) par application de ladite matrice P au vecteur V dont les composantes correspondent aux symboles du préambule : H=P×V.

Les coefficients du filtre linéaire modélisant le canal de communication sont de préférence mis à jour pour chaque paquet, au moyen de la séquence connue de symboles utilisée comme champ de synchronisation au début de chacun des paquets.

Le tableau 1 ci-dessous présente une estimation de la complexité du procédé. MIN signifie l'utilisation d'un algorithme de recherche de minimum, tandis que CORDIC est l'abréviation de l'anglais COordinate Rotation Digital Computer signifiant calcul numérique par rotation de coordonnées, et correspond à un algorithme de calcul de fonction trigonométrique.

Tableau 1

| | | Type d'opération | | | |
|---|---|---|---|---|---|
| | | Addition (réelle) | Multiplication (réelle) | MIN | CORDIC |
| Etape | Calcul des métriques de branche | $(K-M) \times Q^M$ $\times \left( \frac{(M+2)(M-1)}{2} + 2 \right) + (K-M)$ | $(K-M) \times Q^M \times (M+2)$ | 0 | K-M |
| | Mise à jour et comparaison des métriques de chemin cumulées, sélection des branches survivantes | $3 \times (k-M) \times Q^M$ | $(K-M) \times Q^M$ | $(K-M) \times Q^{M-1}$ | 0 |
| | Mise à jour de la phase de référence | K-M | 0 | K-M | 0 |
| | Remontée des noeuds survivants | K-M | K-M | 0 | 0 |

On peut constater que le procédé ne présente pas de surcroît de complexité par rapport à un algorithme classique. La complexité reste raisonnable.

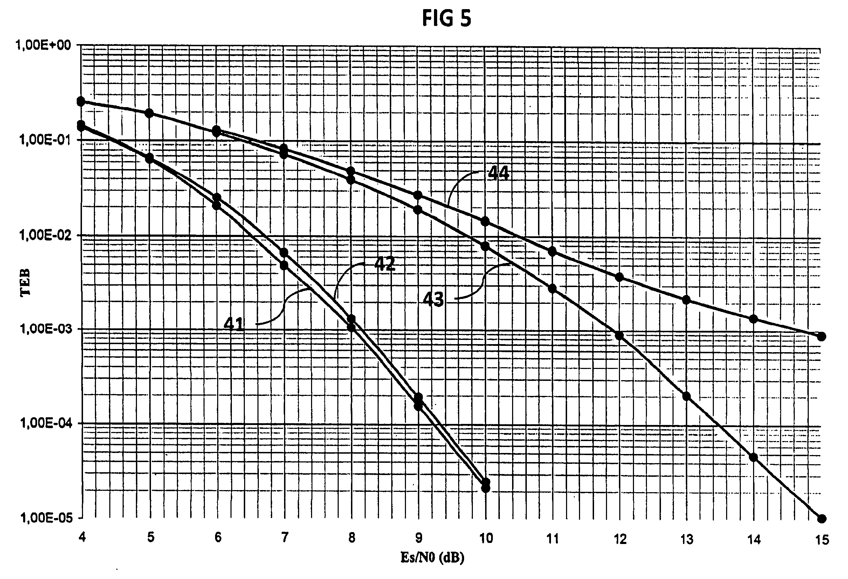

Les courbes de la figure 5 illustrent des résultats de simulation mettant en oeuvre l'invention. Elles représentent le taux d'erreur binaire (TEB) en fonction du rapport signal à bruit Es/N0 en décibels.

La courbe 41 correspond à une mise en oeuvre de l'invention dans le cadre d'une modulation GFSK sans bruit de phase, tandis que la courbe 42 correspond à une mise en oeuvre de invention dans le cadre d'une modulation GFSK avec bruit de phase. La courbe 43 correspond à une mise en oeuvre de l'invention dans le cadre d'une modulation QGFSK sans bruit de phase, tandis que la courbe 44 correspond à une mise en oeuvre de l'invention dans le cadre d'une modulation QGFSK avec bruit de phase.

Comme on peut le constater, le procédé offre de belles performances, bien que la forme de modulation QGFSK soit sensible au bruit de phase.

Ces simulations sont réalisées de la manière suivante:

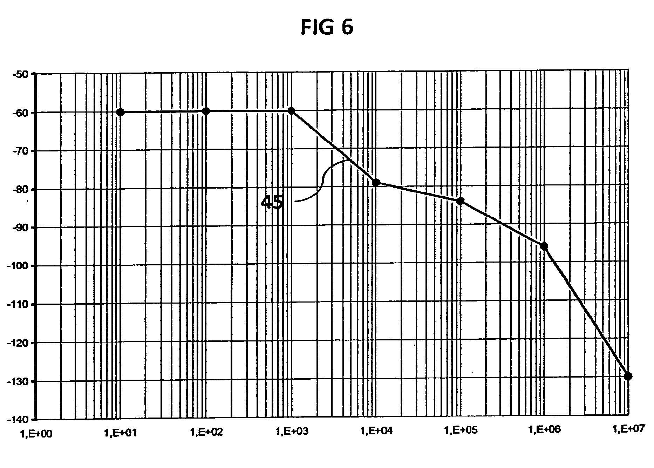

- des paquets de 192 bits constitués d'un préambule de 32 bits et d'une charge utile de 160 bits (tirés aléatoirement selon une loi uniforme), ont été utilisés,
- le canal est modélisé par l'ajout de bruit blanc gaussien et du bruit de phase le cas échéant,
- le bruit de phase est obtenu au moyen de bruit blanc filtré dans le domaine fréquentiel à l'aide du profil de bruit de phase à tester représenté sur la figure 6 par la courbe 45 illustrant la densité spectrale de puissance (en dB/Hz) en fonction de la fréquence Hz,
- la synchronisation est supposé réalisée de manière idéale,
- le démodulateur a été implémenté en virgule flottante,
- les paramètres de modulation sont h = 0,5, BT = 0,5 pour la forme GFSK et h = 0,25, BT = 0,5 pour la forme QGFSK (le codage de Gray ayant été implémenté pour cette forme).

**Revendications**

1. Procédé de démodulation et de décodage d'un signal reçu modulé sur Q états par déplacement de fréquence avec filtrage gaussien, ledit signal étant reçu d'un canal de communication et comportant un message constitué de symboles de message, ledit procédé étant **caractérisé en ce que**, pour déterminer un symbole de message,

   - une pluralité d'incréments de phase possibles sont estimés par l'application d'un filtre linéaire à une pluralité de séquences de M produits de modulation sur Q états par déplacement de phase de symboles de message consécutifs possibles,

- une phase cumulée des précédentes itérations du procédé est ajoutée à chacun desdits incréments de phase possibles pour donner une phase estimée,
- le symbole de message est déterminé par sélection des symboles consécutifs possibles dont la phase estimée est la plus proche du signal reçu,

une nouvelle phase cumulée étant déterminée par l'ajout à la phase cumulée des précédentes itérations du procédé de l'incrément de phase correspondant à la modulation par déplacement de phase du symbole de message ainsi déterminée, ladite nouvelle phase cumulée étant la phase cumulée pour l'itération subséquente du procédé, **caractérisé en ce que**

- lorsque la modulation par déplacement de fréquence est une modulation par déplacement de fréquence à filtrage gaussien à deux états, la modulation par déplacement de phase est une modulation par déplacement de phase binaire BPSK, ou
- lorsque la modulation par déplacement de fréquence est une modulation par déplacement de fréquence à filtrage gaussien à quatre états, la modulation par déplacement de phase est une modulation par déplacement de phase quaternaire QPSK.

2. Procédé selon la revendication précédente, dans lequel le procédé met en oeuvre une reconstruction itérative du signal modulé par déplacement de fréquence avec filtrage gaussien GFSK ou QGFSK reçu à partir de signaux de référence modulés par déplacement de phase BPSK ou QPSK, respectivement, le $k^{\text{ème}}$ symbole d'un message modulé par déplacement de fréquence à filtrage gaussien correspondant à la somme de produits de modulations par déplacement de phase du même message, les produits de modulations étant pondérés par les coefficients du filtre linéaire modélisant le canal de communication en y incorporant le passage de la modulation par déplacement de phase à la modulation par déplacement de fréquence.

3. Procédé selon l'une des revendications précédente, dans lequel Q=2 et

$$GFSK(k) = \sum_{m=0}^{M-1} H(m)X(k-m)$$

avec

$$X(k) = \prod_{l=1}^{k} BPSK(l)$$

et avec GFSK(k) désignant la modulation par déplacement de fréquence à filtrage gaussien à deux états du $k^{\text{ème}}$ symbole de message, M le nombre de coefficients du filtre linéaire, H(m) le $m^{\text{ème}}$ coefficient dudit filtre linéaire modélisant la réponse impulsionnelle du canal de communication, et BPSK(l) la modulation par déplacement de phase binaire du $l^{\text{ème}}$ symbole du message, ou
Q=4 et

$$QGFSK(k) = \sum_{m=0}^{M-1} H(m)X(k-m)$$

avec

$$X(k) = \prod_{l=1}^{k} QPSK(l)$$

et avec QGFSK(k) désignant la modulation par déplacement de fréquence à filtrage gaussien à quatre états du

k<sup>ème</sup> symbole de message, M le nombre de coefficients du filtre linéaire, H(m) le m<sup>ième</sup>coefficient dudit filtre linéaire modélisant la réponse impulsionnelle du canal de communication, et QPSK(l) la modulation par déplacement de phase quaternaire du l<sup>ème</sup> symbole du message.

4. Procédé selon la revendication précédente, dans lequel la sélection des symboles consécutifs possibles est mise en oeuvre au moyen d'un critère de maximum de vraisemblance.

5. Procédé selon l'une des revendications précédentes, dans lequel la sélection des symboles consécutifs possibles dont la phase estimée est la plus proche du signal reçu est mise en oeuvre au moyen d'un algorithme de Viterbi dont le treillis est déterminé par le filtre linéaire.

6. Procédé selon l'une des revendications précédentes, dans lequel le filtre linéaire est obtenu par minimisation au sens des moindres carrés d'un critère d'erreur quadratique exprimant la différence entre des produits de modulation par déplacement de phase d'une séquence connue de symboles de message et une partie du signal reçu correspondant à ladite séquence connue de symboles de message.

7. Procédé selon l'une des revendications précédentes, dans lequel le filtre linéaire est une estimation d'une réponse impulsionnelle du canal de communication modélisé par M coefficients.

8. Procédé selon la revendication précédente, dans lequel la modélisation de la réponse impulsionnelle du canal de communication prend en compte le passage de la modulation des symboles depuis une modulation par déplacement de phase à une modulation par déplacement de fréquence.

9. Procédé selon l'une des revendications 7 ou 8, dans lequel la réponse impulsionnelle du canal de communication est estimée à partir d'une séquence connue de symboles présente dans le signal reçu, ledit procédé comprenant les étapes suivantes:

   - extraction des symboles correspondant à la séquence connue de symboles contenue dans le signal reçu,
   - construction d'un signal de référence R par produit des modulations par déplacement de phase des symboles de la séquence connue,
   - construction d'une matrice P à partir des composantes du signal de référence R,
   - détermination de la matrice H modélisant la réponse impulsionnelle du canal de communication par application de ladite matrice P à un vecteur V dont les composantes correspondent aux symboles de la séquence connue.

10. Procédé selon la revendication précédente, dans lequel la matrice P correspond à la pseudo-inverse de Penrose d'une matrice de Hankel M de dimension (L-M)xM constituée des composantes du signal de référence R, où L est le nombre de symboles de la séquence connue.

11. Démodulateur-égaliseur pour démoduler et décoder au moins un signal reçu modulé sur Q états par déplacement de fréquence avec filtrage gaussien, comprenant au moins une mémoire et un processeur, ledit processeur étant configuré pour mettre en oeuvre le procédé selon l'une quelconque des revendications précédentes.

12. Récepteur pour recevoir un signal modulé par déplacement de fréquence avec utilisation d'un filtre gaussien GFSK à Q états, comprenant au moins un démodutateur-égaliseur selon la revendication 11.

13. Produit programme d'ordinateur comprenant des instructions de code de programme pour l'exécution des étapes du procédé selon l'une quelconque des revendications 1 à 10, lorsque ledit programme est exécuté par un système de calcul comprenant au moins un processeur.

**Patentansprüche**

1. Verfahren zur Demodulation und Decodierung eines empfangenen, auf Q Zustände modulierten Signals durch Frequenzumtastung mit Gauß-Filterung, wobei das Signal von einem Kommunikationskanal empfangen wird und eine Nachricht umfasst, die aus Nachrichtensymbolen besteht, wobei das Verfahren **dadurch gekennzeichnet ist, dass** zum Bestimmen eines Nachrichtensymbols

   - mehrere mögliche Phaseninkremente durch die Anwendung eines linearen Filters auf mehrere Sequenzen von M Produkten der Phasenumtastungsmodulationen auf Q Zuständen von möglichen aufeinander folgenden Nachrichtensymbolen geschätzt werden,
- eine kumulierte Phase der vorhergehenden Iterationen des Verfahrens zu jedem der möglichen Phaseninkremente hinzugefügt wird, um eine geschätzte Phase zu ergeben,
- das Nachrichtensymbol durch Auswahl der möglichen aufeinander folgenden Symbole bestimmt wird, deren geschätzte Phase am nächsten an dem empfangenen Signal liegt,

wobei eine neue kumulierte Phase durch das Hinzufügen des Phaseninkrements, das der Phasenumtastungsmodulation des so bestimmten Nachrichtensymbols entspricht, zur kumulierten Phase der vorhergehenden Iterationen des Verfahrens bestimmt wird, wobei die neue kumulierte Phase die für die anschließende Iteration des Verfahrens kumulierte Phase ist,
**dadurch gekennzeichnet, dass**

- wenn die Frequenzumtastungsmodulation eine Frequenzumtastungsmodulation mit Gauß-Filterung mit zwei Zuständen ist, die Phasenumtastungsmodulation eine binäre Phasenumtastungsmodulation (BPSK) ist, oder
- wenn die Frequenzumtastungsmodulation eine Frequenzumtastungsmodulation mit Gauß-Filterung mit vier Zuständen ist, die Phasenumtastungsmodulation eine Quadraturphasenumtastungsmodulation (QPSK) ist.

2. Verfahren nach dem vorhergehenden Anspruch, wobei das Verfahren eine iterative Rekonstruktion des durch Frequenzumtastung mit Gauß-Filterung (GFSK oder QGFSK) modulierten Signals durchführt, das ausgehend von durch BPSK- beziehungsweise QPSK-Phasenumtastung modulierten Bezugssignalen empfangen wird, wobei das $k^{te}$ Symbol einer durch Frequenzumtastung mit Gauß-Filterung modulierten Nachricht der Summe von Produkten der Modulationen derselben Nachricht durch Phasenumtastung entspricht, wobei die Produkte der Modulationen durch die Koeffizienten des linearen Filters gewichtet werden, die den Kommunikationskanal durch Aufnehmen des Übergangs von der Phasenumtastungsmodulation zur Frequenzumtastungsmodulation darin modellieren.

3. Verfahren nach einem der vorhergehenden Ansprüche, wobei:

Q=2 und

$$GFSK(k) = \sum_{m=0}^{M-1} H(m)X(k-m)$$

wobei

$$X(k) = \prod_{l=1}^{k} BPSK(l)$$

und wobei GFSK(k) die Modulation durch Frequenzumtastung mit Gauß-Filterung mit zwei Zuständen des $k^{ten}$ Nachrichtensymbols, M die Anzahl der Koeffizienten des linearen Filters, H(m) den $m^{ten}$ Koeffizienten des linearen Filters, der die Impulsantwort des Kommunikationskanals modelliert, und BPSK(l) die Modulation des $l^{ten}$ Symbols der Nachricht durch binäre Phasenumtastung bezeichnet, oder
Q=4 und

$$QGFSK(k) = \sum_{m=0}^{M-1} H(m)X(k-m)$$

wobei

$$X(k) = \prod_{l=1}^{k} QPSK(l)$$

und wobei QGFSK(k) die Modulation durch Frequenzumtastung mit Gauß-Filterung mit vier Zuständen des $k^{ten}$ Nachrichtensymbols, M die Anzahl der Koeffizienten des linearen Filters, H(m) den $m^{ten}$ Koeffizienten des linearen Filters, der die Impulsantwort des Kommunikationskanals modelliert, und QPSK(l) die Modulation des $l^{ten}$ Symbols der Nachricht durch quaternäre Phasenumtastung bezeichnet.

4. Verfahren nach dem vorhergehenden Anspruch, wobei die Auswahl der möglichen aufeinander folgenden Symbole mittels eines Maximum-Likelihood-Kriteriums durchgeführt wird.

5. Verfahren nach einem der vorhergehenden Ansprüche, wobei die Auswahl der möglichen aufeinander folgenden Symbole, deren geschätzte Phase am nächsten an dem empfangenen Signal liegt, mittels eines Viterbi-Algorithmus durchgeführt wird, dessen Trellis durch das lineare Filter bestimmt wird.

6. Verfahren nach einem der vorhergehenden Ansprüche, wobei das lineare Filter durch Minimierung eines Kriteriums des quadratischen Fehlers, der die Differenz zwischen den Produkten der Modulationen durch Phasenumtastung einer bekannten Sequenz von Nachrichtensymbolen und eines Teils des empfangenen Signals ausdrückt, der der bekannten Sequenz von Nachrichtensymbolen entspricht, im Sinne der kleinsten Quadrate erhalten wird.

7. Verfahren nach einem der vorhergehenden Ansprüche, wobei das lineare Filter eine Schätzung einer Impulsantwort des durch M Koeffizienten modellierten Kommunikationskanals ist.

8. Verfahren nach dem vorhergehenden Anspruch, wobei die Modellierung der Impulsantwort des Kommunikationskanals den Übergang der Modulation der Symbole von einer Phasenumtastungsmodulation zu einer Frequenzumtastungsmodulation berücksichtigt.

9. Verfahren nach einem der Ansprüche 7 oder 8, wobei die Impulsantwort des Kommunikationskanals ausgehend von einer bekannten Sequenz von Symbolen geschätzt wird, die in dem empfangenen Signal vorhanden ist, wobei das Verfahren die folgenden Schritte umfasst:

   - Gewinnung von Symbolen, die der bekannten Sequenz von Symbolen entsprechen, die in dem empfangenen Signal enthalten ist,
   - Konstruktion eines Bezugssignals R durch das Produkt der Modulationen der Symbole durch Phasenumtastung der bekannten Sequenz,
   - Konstruktion einer Matrix P ausgehend von den Komponenten des Bezugssignals R,
   - Bestimmung der Matrix H, die die Impulsantwort des Kommunikationskanals modelliert, durch Anwenden der Matrix P auf einen Vektor V, dessen Komponenten den Symbolen der bekannten Sequenz entsprechen.

10. Verfahren nach dem vorhergehenden Anspruch, wobei die Matrix P der Penrose-Pseudoinversen einer Hankel-Matrix M mit der Dimension (L-M)×M entspricht, die durch die Komponenten des Bezugssignals R gebildet ist, wobei L die Anzahl der Symbole der bekannten Sequenz ist.

11. Demodulator-Entzerrer zum Demodulieren und Decodieren von mindestens einem empfangen, durch Frequenzumtastung mit Gauß-Filter auf Q Zustände modulierten Signals, der mindestens einen Speicher und einen Prozessor umfasst, wobei der Prozessor ausgestaltet ist, um das Verfahren nach einem der vorhergehenden Ansprüche durchzuführen.

12. Empfänger zum Empfangen eines durch Frequenzumtastung unter Verwendung eines GFSK-Gauß-Filters auf Q Zustände modulierten Signals, der mindestens einen Demodulator-Entzerrer nach Anspruch 11 umfasst.

13. Computerprogrammprodukt, das Programmcodebefehle für die Ausführung der Schritte des Verfahrens nach einem der Ansprüche 1 bis 10 umfasst, wenn das Programm durch ein Rechensystem ausgeführt wird, das mindestens einen Prozessor umfasst.

**Claims**

1. A method for demodulation and decoding of a received signal modulated on Q states by frequency-shift-keying with Gaussian filtering, said signal being received from a communication channel and comprising a message consisting of message symbols, said method being **characterized in that**, to determine a message symbol,

   - a plurality of possible phase increments are estimated by application of a linear filter to a plurality of sequences of M products of modulation on Q states by phase-shift-keying of possible consecutive message symbols,
   - a cumulated phase of the preceding iterations of the method is added to each of said possible phase increments to give an estimated phase,
   - the message symbol is determined by selection of the possible consecutive symbols whereof the estimated phase is the closest to the received signal,

   wherein a new cumulated phase is determined by addition to the cumulated phase of the preceding iterations of the method of the phase increment corresponding to phase-shift-keying of the message symbol as determined, said new cumulated phase being the cumulated phase for the subsequent iteration of the method,
   **characterised in that**

   - when modulation by frequency-shift-keying is modulation by frequency-shift-keying with Gaussian filtering with two states, phase-shift-keying modulation is binary phase-shift-keying BPSK, or
   - when modulation by frequency-shift-keying is modulation by frequency-shift-keying with Gaussian filtering with four states, phase-shift-keying modulation is quaternary phase-shift-keying QPSK.

2. The method according to the preceding claim, wherein the method comprises iteratively reconstruction of the received signal modulated by frequency-shift-keying with Gaussian filtering GFSK or QGFSK from modulated reference signals modulated by phase-shift-keying BPSK or QPSK, respectively, wherein the $k^{th}$ symbol of a message modulated by frequency-shift-keying with Gaussian filtering corresponds to a sum of products of modulations by phase-shift-keying of the same message, the products of modulations being weighted by the coefficients of a linear filter which models the communication channel by incorporating therein shifting from phase-shift-keying modulation to frequency-shift-keying modulation.

3. The method according to one of the preceding claims, wherein
   Q=2 and

$$GFSK(k) = \sum_{m=0}^{M-1} H(m)X(k-m)$$

   with

$$X(k) = \prod_{l=1}^{k} BPSK(l)$$

   and with GFSK(k) designating modulation by frequency-shift-keying with Gaussian filtering with two states of the $k^{th}$ message symbol, M the number of coefficients of the linear filter, H (m) the $m^{th}$ coefficient of said linear filter modelling the impulse response of the communication channel, and BPSK(l) modulation by binary phase-shift-keying of the original $l^{th}$ message symbol, or
   Q=4 and

$$QGFSK(k) = \sum_{m=0}^{M-1} H(m)X(k-m)$$

   with

$$X(k) = \prod_{l=1}^{k} QPSK(l)$$

and with QGFSK(k) designating modulation by frequency-shift-keying with Gaussian filtering with four states of the $k^{th}$ message symbol, M the number of coefficients of the linear filter, H (m) the $m^{th}$ coefficient of said linear filter modelling the impulse response of the communication channel, and QPSK(l) modulation by quaternary phase-shift-keying of the original $l^{th}$ message symbol.

4. The method according to the preceding claim, wherein selection of the possible consecutive symbols is made by means of a maximum likelihood criterion.

5. The method according to one of the preceding claims, wherein selection of the possible consecutive symbols whereof the estimated phase is the closest to the received signal is made by means of a Viterbi algorithm whereof the trellis is determined by the linear filter.

6. The method according to one of the preceding claims, wherein the linear filter is obtained by least squares minimisation of a quadratic error criterion expressing the difference between products of modulation by phase-shift-keying of a known sequence of message symbols and part of the received signal corresponding to said known sequence of message symbols.

7. The method according to one of the preceding claims, wherein the linear filter is an estimation of an impulse response of the communication channel modelled by M coefficients.

8. The method according to the preceding claim, wherein the modelling of the impulse response of the communication channel takes into consideration shifting from a modulation of symbols by phase-shift-keying to a modulation by frequency-shift-keying.

9. The method according to one of Claims 7 or 8, wherein the impulse response of the communication channel is estimated from a known sequence of symbols present in the received signal, said method comprising the following steps:

- extraction of the symbols corresponding to the known sequence of symbols contained in the received signal,
- construction of a reference signal R by product of modulations by phase-shift-keying of symbols of the known sequence,
- construction of a matrix P from the components of the reference signal R,
- determination of the matrix H modelling the impulse response of the communication channel by application of said matrix P to a vector V whereof the components correspond to the symbols of the known sequence.

10. The method according to the preceding claim, wherein the matrix P corresponds to the Penrose pseudo-inverse of a Hankel matrix M of dimension (L-M)×M consisting of the components of the reference signal R, where L is the number of symbols of the known sequence.

11. A demodulator-equalizer for demodulating and decoding at least one received modulated signal on Q states by frequency-shift-keying with Gaussian filtering, comprising at least one memory and one processor, said processor being configured for carrying out the method according to any one of the preceding claims.

12. A receiver for receiving a modulated signal by frequency-shift-keying with use of a Gaussian filter GFSK with Q states, comprising at least one demodulator-equalizer according to claim 11.

13. A computer program product comprising program code instructions for executing the steps of the method according to any one of claims 1 to 10, when said program is executed by a calculation system comprising at least one processor.

**FIG 1**

Lecture de z(k) — S01

Calcul des métriques de branche pour les $Q^M$ états du treillis — S02

$C_{k-M}$

Mise à jour et comparaison des métriques de chemin cumulées — S03

$Z^{-1}$

$C_{k-M+1}$

— S06

sélection des branches survivantes — S04

k<K?   Oui

sélection de l'incrément de phase $\Delta\Phi_{k-M+1}$ — S05

Non

Remontée des nœuds survivants (méthode de chaînage arrière) — S07

b(n)

**FIG 2**

Construction du signal de référence R — S21

Extraction du préambule du signal reçu — S20

Formation d'une matrice de Hankel M — S22

formation d'un vecteur V — S24

Calcul de la pseudo-inverse P de la matrice de Hankel M — S23

détermination du filtre : H=PV → H

S25

**FIG 3**

**FIG 4**

FIG 5

# FIG 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MICHAEL SPETH et al.** MLSE Based Detection for GFSK Signals with Arbitrary Modulation Index. *Int. Zurich Seminar on Communications,* 18 Février 2004, ISBN 978-0-7803-8329-6, 228-231
- **BENSEKER et al.** A 1mm2 1.3mW GSM/EDGE Digital Baseband Receiver ASIC in 0.13µm CMOS. *VLSI System ou Chip Conference,* 27 Septembre 2010, ISBN 978-1-4244-6469-2, 183-188
- **MICHAEL READY et al.** Demodulation of Cochannel FSK Signals Using Joint Maximum Likelihood Sequence Estimation. *Proceedings of the ASILOMAR Conference,* 01 Novembre 1993, vol. 2/2, 1412-1415